# EUROPÄISCHE PATENTSCHRIFT

(11) **EP 1 912 470 B1**
(45) Veröffentlichungstag und Bekanntmachung des Hinweises auf die Patenterteilung: **30.10.2013**
(21) Anmeldenummer: 07114424.0
(22) Anmeldetag: 16.08.2007
(51) Int. Cl.: H04R 25/00

(54) **Verfahren zur Dynamikkompression eines Audiosignals und entsprechende Hörvorrichtung**
Method for the dynamic compression of an audio signal and corresponding hearing device
Procédé pour la compression dynamique d'un signal audio et appareil auditif correspondant

(30) Priorität: 09.10.2006 DE 102006047694
(43) Veröffentlichungstag der Anmeldung: 16.04.2008
(73) Patentinhaber: Siemens Audiologische Technik GmbH, 91058 Erlangen (DE)
(72) Erfinder: Chalupper, Josef, 85307 Paunzhausen (DE); Fruhmann, Markus, 81673 München (DE)
(74) Vertreter: Maier, Daniel Oliver

(56) Entgegenhaltungen:
- WO-A1-99/65276
- DE-A1- 19 703 228
- DE-A1-102004 044 565
- US-A1- 2003 044 034
- QIN LI ET AL: "Properties for Modulation Spectral Filtering", 2005 IEEE INTERNATIONAL CONFERENCE ON ACOUSTICS, SPEECH, AND SIGNAL PROCESSING (IEEE CAT. NO.05CH37625) IEEE PISCATAWAY, NJ, USA, IEEE, PISCATAWAY, NJ, Bd. 4, 18. März 2005 (2005-03-18), Seiten 521-524, XP010792597, DOI: DOI:10.1109/ICASSP.2005.1416060 ISBN: 978-0-7803-8874-1

## Beschreibung

Die vorliegende Erfindung betrifft ein Verfahren zur Dynamikkompression eines Audiosignals sowie eine entsprechende Hörvorrichtung. Unter dem Begriff Hörvorrichtung wird hier generell ein tragbares oder ein nicht tragbares Audiogerät, insbesondere ein Hörgerät, ein Headset oder ein Kopfhörer, verstanden.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO), Indem-Ohr-Hörgeräte (IdO) und Concha-Hörgeräte bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

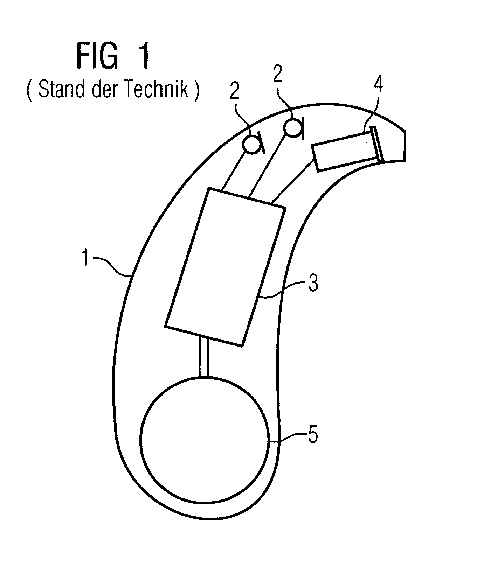

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Stromversorgung des Hörgeräts und insbesondere die der Signalverarbeitungseinheit 3 erfolgt durch eine ebenfalls ins Hörgerätegehäuse 1 integrierte Batterie 5.

Audiosignale weisen eine bestimmte Dynamik auf, die den Unterschied zwischen dem niedrigsten und dem höchsten Pegel charakterisiert. Natürlich vorkommende Audiosignale weisen in der Regel eine hohe Dynamik auf, während Audiogeräte, wie beispielsweise Rundfunkgeräte und Hörgeräte, in ihrem Ausgangssignal eine deutlich geringere Dynamik aufweisen. Aus diesem Grund wird bei den genannten Geräten bzw. bei den entsprechenden Verarbeitungsverfahren eine Dynamikkompression durchgeführt.

Bei der Dynamikkompression handelt es sich um ein nicht lineares Verfahren. Daher treten insbesondere bei schnellen Regelzeitkonstanten hörbare Verzerrungen auf, die zu einer Verminderung der Klangqualität führen. Außerdem nimmt aufgrund der Trägheit des Regelsystems die "effektive Kompression" mit zunehmender Modulationsfrequenz ab. Für natürliche Signale ist es deshalb nahezu unmöglich, die effektive Kompressionsrate vorherzusagen bzw. gezielt als Funktion der Modulationsfrequenz einzustellen. Das erste Problem der Verzerrungen bei schnellen Regelzeitkonstanten kann durch eine entsprechend langsame Regelung umgangen werden. Das zweite Problem der Trägheit des Regelsystems erfordert jedoch eher eine schnelle Regelung, was jedoch der genannten Lösung des ersten Problems widerspricht.

Aus dem Artikel "PROPERTIES FOR MODULATION SPECTRAL FILTERING", Qin Li und Les Atlas, ICASSP 2005, Seiten 521 bis 524 ist eine kohärente Demodulation zur Gewinnung einer komplexen Hüllkurve bekannt.

Aus der Patentschrift DE 197 03 228 B4 ist ein Verfahren zur Verstärkung von Eingangssignalen eines Hörgeräts bekannt, bei dem zur Gewährleistung einer Dynamikkompression zusätzlich zur Erfassung des Signalpegels des Eingangssignals eine Modulationsfrequenzanalyse durchgeführt wird.

Darüber hinaus beschreibt die Druckschrift DE 10 2004 044 565 A1 ein Verfahren zur Begrenzung des Dynamikbereichs von Audiosignalen. Dabei wird die Dynamikbereichsbegrenzung in Abhängigkeit von der Momentanfrequenz des zu komprimierenden Audiosignals geregelt.

Die Aufgabe der vorliegenden Erfindung besteht darin, eine Dynamikkompression möglichst ohne Verzerrungen in Echtzeit durchführen zu können.

Erfindungsgemäß wird diese Aufgabe gelöst durch ein Verfahren zur Dynamikkompression eines Audiosignals durch Ermitteln eines Modulationsspektrums des Audiosignals, Modifizieren des Modulationsspektrums entsprechend einer vorbestimmten Kompressionsfunktion und Rückgewinnen eines modifizierten Audiosignals aus dem modifizierten Modulationsspektrum.

Darüber hinaus wird erfindungsgemäß bereitgestellt eine Hörvorrichtung mit einer ersten Verarbeitungseinrichtung zum Ermitteln eines Modulationsspektrums eines Audiosignals, einer Modifikationseinrichtung zum Modifizieren des Modulationsspektrums entsprechend einer vorbestimmten Kompressionsfunktion für eine Dynamikkompression des Audiosignals und einer zweiten Verarbeitungseinrichtung zum Rückgewinnen eines modifizierten Audiosignals aus dem modifizierten Modulationsspektrum.

In vorteilhafter Weise wird somit keine Kompression im Zeit- oder Frequenzbereich des Audiosignals, sondern direkt im Modulationsspektrum durchgeführt. Während bei konventionellen Dynamikkompressionssystemen Verzerrungen im Modulationsspektrum entstehen, können Verzerrungen mit dem erfindungsgemäßen Ansatz im Modulationsspektrum verhindert werden, da das Modulationsspektrum direkt modifiziert wird. Durch die direkte Modifikation der Modulationsspektren kann außerdem die gewünschte effektive Kompressionsrate direkt eingestellt werden.

Vorzugsweise wird die erfindungsgemäße Dynamikkompression in mehreren Frequenzkanälen separat durchgeführt. Damit können die Kompressionsraten sehr selektiv in den einzelnen Frequenzkanälen gewählt werden.

Entsprechend einer besonderen Ausführungsform wird das Modulationsspektrum aus einer durch kohärente Demodulation gewonnenen, komplexen Hüllkurve des Audiosignals ermittelt. Auf diese Weise kann vermieden werden, dass die Phaseninformation der Hüllkurve bei der Kompression verloren geht.

Gemäß einer weiteren Ausführungsform wird das Modulationsspektrum durch Schätzen mit Hilfe instantaner Frequenzbestimmung der Hüllkurvenmodulation ermittelt. Durch das Schätzen können aufwändige Berechnungsalgorithmen vermieden werden.

Das Schätzen kann schritthaltend mit Hilfe eines oder mehrerer Oszillationsdetektoren erfolgen. Somit lassen sich rasch und einfach Schätzwerte des Modulationsspektrums gewinnen.

Die oben genannte Aufgabe wird auch gelöst durch ein Verfahren zur Dynamikkompression eines Audiosignals durch Gewinnen einer komplexen Hüllkurve des Audiosignals, zeitvariante Modulationsfilterung der komplexen Hüllkurve entsprechend einer vorgebbaren Kompressionsvorschrift und Rückgewinnen eines modifizierten Audiosignals aus der gefilterten Hüllkurve.

Darüber hinaus wird erfindungsgemäß bereitgestellt eine entsprechende Hörvorrichtung mit einer ersten Verarbeitungseinrichtung zum Gewinnen einer komplexen Hüllkurve eines Audiosignals, einer Filtereinrichtung zur zeitvarianten Modulationsfilterung der komplexen Hüllkurve entsprechend einer vorgegebenen Kompressionsvorschrift und einer zweiten Verarbeitungseinrichtung zum Rückgewinnen eines modifizierten Audiosignals aus der gefilterten Hüllkurve.

Vorzugsweise wird die Modulationsfilterung durch die Instantanfrequenz der Hüllkurve gesteuert. Darüber hinaus wird die Qualität der Modulationsfilterung auch dadurch erhöht, dass sie durch einen aktuellen Pegel der Hüllkurve gesteuert wird.

Auch bei dieser Lösungsvariante der zeitvarianten Modulationsfilterung ist es günstig, die Dynamikkompression in mehreren Frequenzkanälen separat durchzuführen.

Die vorliegende Erfindung ist anhand der beigefügten Zeichnungen näher erläutert, in denen zeigen:
- FIG 1: ein Hörgerät mit seinen wesentlichen Elektronikbestandteilen;
- FIG 2: ein Blockschaltbild gemäß einer ersten Ausführungsform einer Dynamikkompression;
- FIG 3: ein Blockschaltbild eines zweiten Ausführungsbeispiels einer erfindungsgemäßen Dynamikkompression, und
- FIG 4: ein Blockschaltdiagramm eines dritten Ausführungsbeispiels einer erfindungsgemäßen Dynamikkompression.

Die nachfolgend näher geschilderten Ausführungsbeispiele stellen bevorzugte Ausführungsformen der vorliegenden Erfindung dar.

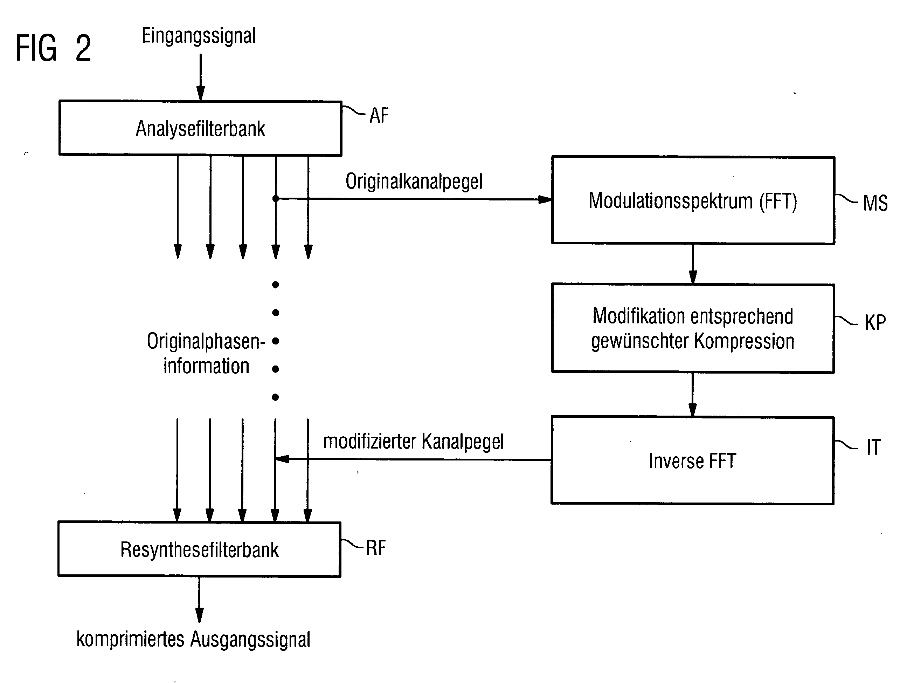

Das in FIG 2 wiedergegebene Blockschaltbild symbolisiert ein erstes Ausführungsbeispiel der vorliegenden Erfindung, bei dem das Modulationsspektrum durch FFT (Fast Fourier Transformation) gewonnen wird. Zunächst wird jedoch das Eingangssignal in seine Frequenzbänder zerlegt. Dies erfolgt beispielsweise ebenfalls durch eine FFT, oder aber wie in dem in FIG 2 dargestellten Beispiel durch eine Analysefilterbank AF. Es ergeben sich daraus die Signale in den einzelnen Frequenzkanälen mit den Originalphaseninformationen.

FIG 2 zeigt nun die Verarbeitung eines dieser Frequenzkanäle, wobei das entsprechende Signal einen Originalkanalpegel besitzt. In einer anschließenden Einheit MS wird in kurzen, überlappenden Zeitfenstern ("Overlap add") für den entsprechenden Kanal das Modulationsspektrum berechnet. Hierzu wird wiederum die FFT herangezogen. Anschließend erfolgt in einer Einheit KP die Modifikation des Modulationsspektrums entsprechend der gewünschten Kompressionsrate. Hierzu wird mit Hilfe der gewünschten effektiven Kompressionsrate als Funktion der Modulationsfrequenz direkt ein Ziel-Modulationsspektrum berechnet. In einer nachgeschalteten inversen Transformationseinheit IT wird per Inverser FFT ("Overlap add") aus diesem Ziel-Modulationsspektrum die Einhüllende des entsprechenden Kanals und Zeitfensters berechnet. Diese Einhüllende repräsentiert den modifizierten Kanalpegel und wird mit den Phasen in einer Resynthesefilterbank RF rekombiniert, so dass wieder ein Zeitsignal entsteht.

Die Kompression wird also hier direkt im Modulationsspektrum durchgeführt, so dass Verzerrungen größtenteils verhindert werden können.

Die Dynamikkompression entsprechend dem ersten Ausführungsbeispiel von FIG 2 kann jedoch unter gewissen Bedingungen Nachteile aufweisen. Zum einen benötigt die Bestimmung des Modulationsspektrums ein Zeitfenster. Dabei besteht das Problem, einen optimalen Kompromiss für die Länge des Zeitfensters zu finden. Bei zu kurzem Fenster werden lange Modulationsfrequenzen nicht aufgelöst, was eine schlechte Frequenzauflösung bedeutet. Ein zu langes Fenster hingegen führt zu einer zusätzlichen Verzögerung und damit zu einer schlechten Klangqualität des Hörgeräts aufgrund von Wechselwirkungen mit Direktschall. Das Lippenlesen wird hierdurch erschwert. Eine Lösung dieses Problems besteht beispielsweise darin, dass das Modulationsspektrum mit Hilfe instantaner Frequenzbestimmung (z. B. mit einem oder mehreren Oszillationsdetektoren) der Hüllkurvenmodulationen geschätzt wird. Hierzu wird also der Block MS von FIG 2 durch eine entsprechende Schätzeinheit, die unten näher beschrieben wird, ersetzt.

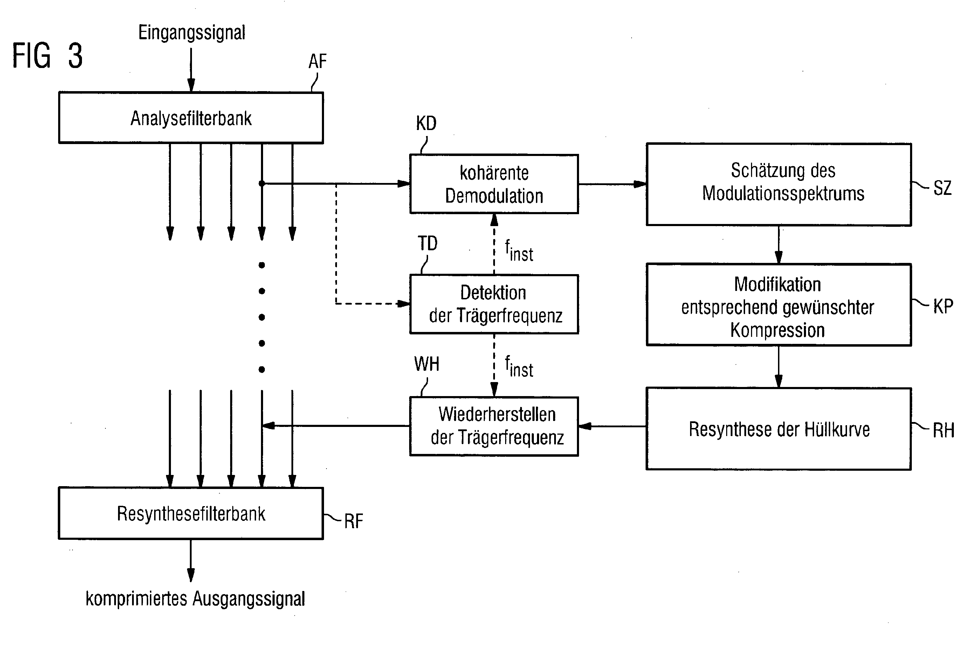

Ein weiteres Problem der Ausführungsform von FIG 2 kann unter Umständen darin bestehen, dass Modifikationen im Modulationsspektrum zu (neuen) Verzerrungen führen. Diese Problematik ist in dem oben erwähnten Artikel "PROPERTIES FOR MODULATION SPECTRAL FILTERING" angesprochen. Eine Lösung dieses Problems besteht darin, verbesserte Methoden zur Hüllkurven- und Trägerschätzung, z. B. komplexe Hüllkurvendetektion, heranzuziehen. Aus den oben genannten Lösungsansätzen ist das zweite Ausführungsbeispiel gemäß FIG 3 entstanden. Wie in dem Beispiel von FIG 2 wird zunächst das Eingangssignal in einer Analysefilterbank AF in Frequenzkanäle zerlegt. Das Signal jedes Kanals wird dann in einer Einheit KD einer kohärenten Demodulation unterzogen, wodurch sich eine komplexe Hüllkurve gewinnen lässt. Zur Steuerung dieser kohärenten Demodulation KD ist die instantane Frequenz fᵢₙₛₜ notwendig. Diese wird durch einen Trägerfrequenzdetektor TD gewonnen, der das Signal des jeweiligen Kanals analysiert.

Die komplexe Hüllkurve wird einer Schätzeinheit SZ zugeführt, die daraus das Modulationsspektrum schätzt. Anschließend erfolgt wie in dem Beispiel von FIG 2 eine Modifikation des Modulationsspektrums entsprechend einer gewünschten Kompressionsrate in einer Kompressionseinheit KP. Danach wird eine modifizierte Hüllkurve in einer Resyntheseeinheit RH gewonnen.

In einer Wiederherstellungseinheit WH wird eine Trägerfrequenz im jeweiligen Kanal auf der Basis der instantanen Frequenz fᵢₙₛₜ des Trägerfrequenzdetektors TD wieder hergestellt.

Hierzu wird die Hüllkurveninformation aus der Resyntheseeinheit RH verwendet. Das Ausgangssignal der Wiederherstellungseinheit WH entspricht einem modifizierten Kanalpegel, der in der Resynthesefilterbank RF dazu benutzt wird, das letztlich resultierende, komprimierte Ausgangssignal herzustellen.

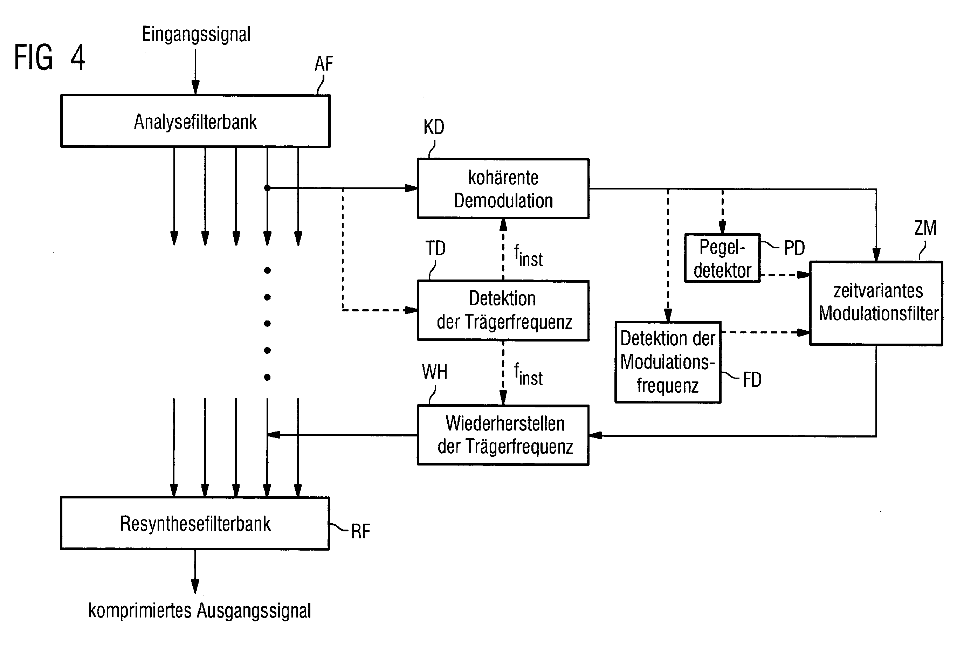

FIG 4 zeigt schließlich eine dritte Ausführungsform einer Signalverarbeitungseinheit zur Durchführung der erfindungsgemäßen Dynamikkompression. Der Aufbau der in FIG 4 symbolisierten Verarbeitungseinheit entspricht im linken und mittleren Teil dem von FIG 3. Dies bedeutet, dass auch hier aus dem Eingangssignal ein komplexes Hüllkurvensignal durch kohärente Demodulation KD erzeugt wird. Aus der komplexen Hüllkurve wird nun aber nicht das Modulationsspektrum geschätzt oder berechnet, sondern es wird im Zeitbereich weitergearbeitet. Dabei nimmt ein zeitvariantes Modulationsfilter ZM die komplexe Hüllkurve entgegen. Parallel hierzu werden aus der komplexen Hüllkurve der Pegel durch einen Pegeldetektor PD und die Modulationsfrequenz durch einen Oszillationsdetektor bzw. Frequenzdetektor FD ermittelt. Der aktuelle Pegel und die aktuelle Modulationsfrequenz werden zur Steuerung des zeitvarianten Modulationsfilters ZM verwendet. Das zeitvariante Modulationsfilter ZM wurde bereits vorab mit dem entsprechenden Kompressionswert bzw. den entsprechenden Kompressionswerten versehen. Im Falle eines Hörgeräts wurden die Kompressionswerte bzw. Kompressionsraten individuell bei der Anpassung an den Hörgeräteträger ermittelt. Letztendlich verändert das zeitvariante Modulationsfilter ZM die Hüllkurve in Abhängigkeit von dem aktuellen Pegel und der aktuellen Modulationsfrequenz unter Berücksichtigung der gewünschten Dynamikkompression. Das Ausgangssignal wird wie oben bereits geschildert der Wiederherstellungseinheit WH zugeführt.

In vorteilhafter Weise ist somit eine Dynamikkompression ohne wesentliche Verzerrungen praktisch in Echtzeit zu realisieren.

## Patentansprüche

1. Verfahren zur Dynamikkompression eines Audiosignals durch
- Ermitteln eines Modulationsspektrums des Audiosignals,
- Modifizieren des Modulationsspektrums entsprechend einer vorbestimmten Kompressionsfunktion und
- Rückgewinnen eines modifizierten Audiosignals aus dem modifizierten Modulationsspektrum.

2. Verfahren nach Anspruch 1, wobei die genannte Verarbeitung zur Dynamikkompression in mehreren Frequenzkanälen separat durchgeführt wird.

3. Verfahren nach Anspruch 1 oder 2, wobei das Modulationsspektrum aus einer durch kohärente Demodulation gewonnenen, komplexen Hüllkurve des Audiosignals ermittelt wird.

4. Verfahren nach einem der vorhergehenden Ansprüche, wobei das Modulationsspektrum durch Schätzen mit Hilfe instantaner Frequenzbestimmung der Hüllkurvenmodulation ermittelt wird.

5. Verfahren nach Anspruch 4, wobei das Schätzen schritthaltend mit Hilfe eines oder mehrerer Oszillationsdetektoren erfolgt.

6. Hörvorrichtung mit
- einer ersten Verarbeitungseinrichtung (MS) zum Ermitteln eines Modulationsspektrums eines Audiosignals,
- einer Modifikationseinrichtung (KP) zum Modifizieren des Modulationsspektrums entsprechend einer vorbestimmten Kompressionsfunktion für eine Dynamikkompression des Audiosignals und
- einer zweiten Verarbeitungseinrichtung (IT) zum Rückgewinnen eines modifizierten Audiosignals aus dem modifizierten Modulationsspektrum.

7. Hörvorrichtung nach Anspruch 6, die eine Analysefilterbank (AF) und eine Resynthesefilterbank (RF) aufweist, um die Verarbeitung in mehreren Frequenzkanälen getrennt durchzuführen.

8. Hörvorrichtung nach Anspruch 6 oder 7, die eine Demodulationseinrichtung (KD) zur kohärenten Demodulation aufweist, um eine komplexe Hüllkurve zu gewinnen.

9. Hörvorrichtung nach einem der Ansprüche 6 bis 8, wobei die erste Verarbeitungseinrichtung eine Schätzeinheit (SZ) aufweist, um mit Hilfe instantaner Frequenzbestimmung der Hüllkurvenmodulation das Modulationsspektrum zu ermitteln.

10. Hörvorrichtung nach Anspruch 9, wobei die Schätzeinheit (SZ) einen oder mehrere Oszillationsdetektoren aufweist, um die Frequenz zu bestimmen.

11. Verfahren zur Dynamikkompression eines Audiosignals durch
- Gewinnen einer komplexen Hüllkurve des Audiosignals,
- zeitvariante Modulationsfilterung der komplexen Hüllkurve entsprechend einer vorgebbaren Kompressionsvorschrift und
- Rückgewinnen eines modifizierten Audiosignals aus der gefilterten Hüllkurve.

12. Verfahren nach Anspruch 11, wobei die Modulationsfilterung durch die Instantanfrequenz der Hüllkurve gesteuert wird.

13. Verfahren nach Anspruch 11 oder 12, wobei die Modulationsfilterung durch einen aktuellen Pegel der Hüllkurve gesteuert wird.

14. Verfahren nach einem der Ansprüche 11 bis 13, wobei die genannte Verarbeitung zur Dynamikkompression in mehreren Frequenzkanälen separat durchgeführt wird.

15. Hörvorrichtung mit
- einer ersten Verarbeitungseinrichtung (KD) zum Gewinnen einer komplexen Hüllkurve eines Audiosignals,
- einer Filtereinrichtung (ZM) zur zeitvarianten Modulationsfilterung der komplexen Hüllkurve entsprechend einer vorgegebenen Kompressionsvorschrift und
- einer zweiten Verarbeitungseinrichtung (WH) zum Rückgewinnen eines modifizierten Audiosignals aus der gefilterten Hüllkurve.

16. Hörvorrichtung nach Anspruch 15, wobei die Filtereinrichtung (ZM) von einer Modulationsfrequenzdetektionseinheit (FD), die die Instantanfrequenz der Hüllkurve detektiert, gesteuert wird.

17. Hörvorrichtung nach Anspruch 15 oder 16, wobei die Filtereinrichtung (ZM) von einem Pegeldetektor (PD), mit dem der aktuelle Pegel der Hüllkurve detektierbar ist, gesteuert wird.

18. Hörvorrichtung nach einem der Ansprüche 15 bis 17, die eine Analysefilterbank (AF) und eine Resynthesefilterbank (RF) aufweist, so dass die Verarbeitung separat in mehreren Frequenzkanälen durchführbar ist.

## Claims

1. Method for dynamic range compression of an audio signal by
- determining a modulation spectrum of the audio signal,
- modifying the modulation spectrum corresponding to a predefined compression function and
- recovering a modified audio signal from the modified modulation spectrum.

2. Method according to claim 1, wherein said processing for dynamic range compression is separately carried out in a plurality of frequency channels.

3. Method according to claim 1 or 2, wherein the modulation spectrum is determined from a complex envelope of the audio signal obtained by coherent demodulation.

4. Method according to any one of the preceding claims, wherein the modulation spectrum is ascertained by estimation using instantaneous frequency determination of the envelope modulation.

5. Method according to claim 4, wherein the estimation takes place in real time using one or more oscillation detector(s).

6. Hearing device comprising
- a first processing device (MS) for determining a modulation spectrum of an audio signal,
- a modulation device (KP) for modifying the modulation spectrum corresponding to a predefined compression function for a dynamic range compression of the audio signal and
- a second processing device (IT) for recovering a modified audio signal from the modified modulation spectrum.

7. Hearing device according to claim 6, which comprises an analysis filter bank (AF) and a resynthesis filter bank (RF) to separately carry out the processing in a plurality of frequency channels.

8. Hearing device according to claim 6 or 7, which comprises a demodulator (KD) for coherent demodulation to obtain a complex envelope.

9. Hearing device according to any one of claims 6 to 8, wherein the first processing device has an estimation unit (SZ) to determine the modulation spectrum with the aid of instantaneous frequency determination of the envelope modulation.

10. Hearing device according to claim 9, wherein the estimation unit (SZ) comprises one or more oscillation detector(s) to determine the frequency.

11. Method for dynamic range compression of an audio signal by
- obtaining a complex envelope of the audio signal,
- time-variant modulation filtering of the complex envelope corresponding to a predeterminable compression rule and
- recovering a modified audio signal from the filtered envelope.

12. Method according to claim 11, wherein modulation filtering is controlled by the instantaneous frequency of the envelope.

13. Method according to claim 11 or 12, wherein modulation filtering is controlled by a current level of the envelope.

14. Method according to any one of the preceding claims 11 to 13, wherein said processing for dynamic range compression is separately carried out in a plurality of frequency channels.

15. Hearing device comprising
- a first processing device (KD) for obtaining a complex envelope of an audio signal,
- a filter (ZM) for time-variant modulation filtering of the complex envelope corresponding to a predefined compression rule and
- a second processing device (WH) for recovering a modified audio signal from the filtered envelope.

16. Hearing device according to claim 15, wherein the filter (ZM) is controlled by a modulation frequency detection unit (FD) which detects the instantaneous frequency of the envelope.

17. Hearing device according to claim 15 or 16, wherein the filter (ZM) is controlled by a level detector (PD) with which the current level of the envelope can be detected.

18. Hearing device according to any one of claims 15 to 17, which comprises an analysis filter bank (AF) and a resynthesis filter bank (RF), so processing can be separately carried out in a plurality of frequency channels.

## Revendications

1. Procédé de compression dynamique d'un signal audio par
- détermination d'un spectre de modulation du signal audio,
- modification du spectre de modulation conformément à une fonction de compression déterminée à l'avance et
- récupération d'un signal audio modifié à partir du spectre de modulation modifié.

2. Procédé suivant la revendication 1, dans lequel le traitement mentionné de compression dynamique est effectué séparément dans plusieurs canaux de fréquence.

3. Procédé suivant la revendication 1 ou 2, dans lequel on détermine le spectre de modulation à partir d'une courbe enveloppe du signal audio, qui est complexe et qui est obtenue par une démodulation cohérente.

4. Procédé suivant l'une des revendications précédentes, dans lequel on détermine le spectre de modulation par estimation à l'aide d'une détermination instantanée de fréquence de la modulation de la courbe enveloppe.

5. Procédé suivant la revendication 4, dans lequel on effectue l'estimation en temps réel à l'aide d'un détecteur ou de plusieurs détecteurs d'oscillation.

6. Prothèse auditive comprenant
- un premier dispositif (MS) de traitement pour la détermination d'un spectre de modulation d'un signal audio,
- un dispositif ( KP ) de modification pour la modification du spectre de modulation conformément à une fonction de compression déterminée à l'avance pour une compression dynamique du signal audio et
- un deuxième dispositif ( IT ) de traitement pour la récupération d'un signal audio modifié à partir du spectre de modulation modifié.

7. Prothèse auditive suivant la revendication 6, qui a une base ( AF ) de filtre d'analyse et une base ( RF ) de filtre de resynthèse, pour effectuer de manière séparée le traitement dans plusieurs canaux de fréquence.

8. Prothèse auditive suivant la revendication 6 ou 7, qui a un dispositif ( KD ) de démodulation pour la démodulation cohérente, afin d'obtenir une courbe enveloppe complexe.

9. Prothèse auditive suivant l'une des revendications 6 à 8, dans laquelle le premier dispositif de traitement a une unité ( SZ ) d'évaluation, pour déterminer le spectre de modulation à l'aide d'une détermination de fréquence instantanée de la modulation de la courbe d'enveloppe.

10. Prothèse auditive suivant la revendication 9, dans laquelle l'unité ( SZ ) d'évaluation a un détecteur ou plusieurs détecteurs d'oscillation, pour déterminer la fréquence.

11. Procédé de compression dynamique d'un signal audio par
- obtention d'une courbe enveloppe complexe du signal audio,
- filtrage de modulation variable en fonction du temps de la courbe enveloppe complexe conformément à une prescription de compression pouvant être donnée à l'avance et
- récupération d'un signal audio modifié à partir de la courbe enveloppe filtrée.

12. Procédé suivant la revendication 11, dans lequel on commande le filtrage de modulation par la fréquence instantanée de la courbe enveloppe.

13. Procédé suivant la revendication 11 ou 12, dans lequel on commande le filtrage de modulation par un niveau présent de la courbe enveloppe.

14. Procédé suivant l'une des revendications 11 à 13, dans lequel on effectue séparément dans plusieurs canaux de fréquence le traitement mentionné de compression dynamique.

15. Prothèse auditive comprenant
- un premier dispositif ( KD ) de traitement d'obtention d'une courbe enveloppe complexe d'un signal audio,
- un dispositif ( ZM ) de filtrage pour le filtrage de modulation variable dans le temps de la courbe enveloppe complexe conformément à une prescription de compression donnée à l'avance et
- un deuxième dispositif ( WH ) de traitement pour la récupération d'un signal audio modifié à partir de la courbe enveloppe filtrée.

16. Prothèse auditive suivant la revendication 15, dans laquelle le dispositif ( ZM ) de filtrage est commandé par une unité ( FD ) de détection de fréquence de modulation, qui détecte la fréquence instantanée de la courbe enveloppe.

17. Prothèse auditive suivant la revendication 15 ou 16, dans laquelle le dispositif ( ZM ) de filtrage est commandé par un détecteur ( PD ) de niveau, par lequel le niveau présent de la courbe enveloppe peut être détecté.

18. Prothèse auditive suivant l'une des revendications 15 à 17, qui a une base ( AF ) de filtre d'analyse et une base ( RF ) de filtre de resynthèse, de manière à pouvoir effectuer le traitement séparément dans plusieurs canaux de fréquence.
